Europäisches Patentamt

(19) European Patent Office

Office européen des brevets

(11) Publication number : **0 534 770 A2**

## (12) EUROPEAN PATENT APPLICATION

(21) Application number : **92308739.9**

(22) Date of filing : **25.09.92**

(51) Int. Cl.⁵ : **G06F 15/78**

(30) Priority : **27.09.91 US 766877**

(43) Date of publication of application :
**31.03.93 Bulletin 93/13**

(84) Designated Contracting States :
**DE FR GB IT**

(71) Applicant : **DELL USA L.P.**
**9505 Arboretum Boulevard**
**Austin, Texas 78759 (US)**

(72) Inventor : **Pan-Ratzlaff, Ruby Y.**
**1206 Haverford**
**Austin, Travis, Texas 78753 (US)**

(74) Representative : **Dowler, Angus Michael et al**
**Abel & Imray Northumberland House 303-306**
**High Holborn**
**London, WC1V 7LH (GB)**

(54) **User transparent system for using any one of a family of processors in a single socket.**

(57) A digital computer system has a socket capable of accepting any one of a family of processors, the family being defined as those processors having commonality of their respective basic input/output system code. Each processor has assigned pins for conducting specified signals, the pins engaging the socket. There is dissimilarity between at least two of the processors of correspondence between at least one of the specified signals and the assigned pins. When such dissimilarly is present, the signal is redirected to the appropriate designated pin for the particular type of processor.

FIG. 3

This invention deals with a digital computer system having a processor socket capable of accepting any one of a family of processors. More particularly, this invention enables automatically accommodating the various processors in the family.

Processors in a family of processors often differ in the assignment of a specified signal to a designated pin. That is, a pin on one of the processors may carry a particular specified signal while the corresponding pin on another of the processors carries a different specified signal.

In the past, it has been common practice to adjust the socket manually for each one of the processors. A jumper wire is placed from one location to another to redirect the particular signal to its assigned pin.

Other prior art solutions to the problem have involved switches that are set to redirect the signal from one pin to another of a particular processor.

Another solution to the problem includes using more than one socket. That is, a socket may be exclusively wired to receive one processor from the family of processors, with a second and third socket wired to accept others of the family. Such a system may include automatically switching those processors in place out of the circuit upon the installation of the last of the processors.

The invention provides a computer system including one of a family of processors capable of operating with the same basic input/output system (BIOS) code and having packages with the same pattern of terminals that require respective assigned signal-to-terminal connections that are the same except for a first terminal, packagemounting means effecting the assigned signal-to-terminal connections for the processor, and control means for detecting which one of the processors is fitted to the package-mounting means and for selecting the signal connection to the first terminal according to which processor is fitted to the package-mounting means.

Preferably, the computer system includes one of a family of processors having respective assigned signalto-terminal connections that are the same except for a first terminal and a second terminal, and control means which connects a first selected signal to the first terminal for a first of the processors and connects that signal to the second terminal for another of the processors.

Preferably, for one of the processors, the control means connects a second selected signal to the second terminal when the first selected signal is connected to the first terminal.

Preferably, for one of the processors, the control means blocks all connections to the first terminal when the first selected signal is connected to the second terminal.

Preferably, the control means includes a memory containing a program for identifying the processor, the memory being connected to the processor, and a logic circuit connected between the memory and the processor for effecting signal connections to the first terminal of the processor.

Preferably, the logic circuit includes a register for storing data identifying the processor.

Preferably, the memory includes a program for identifying the processor and a program for storing data identifying the processor in the register in the logic circuit.

Preferably, the program for identifying the processor is capable of distinguishing between a main processor and a coprocessor.

Preferably, the memory includes basic input/output system (BIOS) code for the processor.

Preferably, the package-mounting means is a socket for engaging pins on the processor package.

The invention provides a digital computer system having a processor socket capable of accepting any one of a plurality of types of processors having assigned pins for conducting specified signals and for engaging the socket, the processors having a common basic input/out system code and dissimilarity of correspondence between at least one of the specified signals and assigned pins, comprising:

(a) a memory, programmed to detect and provide identication of the processor; and

(b) logic circuitry, connected betwen the memory and the processor for redirecting the at least one of the specified signals to another designated pin, as determined by the identification of the processor.

Preferably, the logic circuitry comprises a register for storing the identification of the processor.

Preferably, the logic circuitry further comprises a programmable array of logic (PAL), responsive to the output of the register.

Preferably, the logic circuitry further comprises a gate connected to receive a gating signal from the output of the register and a specified signal from the system, and its output connected to one of the designated pins, for selectively blocking the specified signal from the designated pin.

Preferably, the memory comprises a basic input/output system memory (BIOS).

Preferably, the BIOS comprises a program for reading the type of processor, and a program for detecting the presence or absence of a coprocessor.

Preferably, the BIOS comprises a program for reading the type of processor, coding the type and storing the code in the register, and a program for detecting the presence or absence of a coprocessor, coding the presence of absence and storing the code in the register.

This invention enables the user to simply insert the desired processor from the family of processors into a single socket without concern for installing jumpers or throwing switches. The operation is completely transparent to him.

A digital computer system has a socket capable of accepting any one of a plurality of types of processors having assigned pins for conducting specified signals and for engaging the socket. The processors have a common basic input/output system code and dissimilarity between at least two of the processors of correspondence between at least one of the specified signals and the assigned pins. The Intel Corporation processor types 80486DX, 80486SX and 80487SX, are the processors of the family in this preferred embodiment. Other processors of other families could, of course, be used.

The basic input/output system memory (BIOS) has a program for reading the type of processor, coding the type and storing the code in a register. The BIOS also has a program for detecting the presence or absence of a coprocessor, coding the presence or absence, and storing the code in the register.

A Programmable Array of Logic (PAL) is interposed between the register and the socket. The PAL is connected to certain of the pins and, depending upon the contents stored in the register, reroutes signals to other pins. A gate is used to completely block a signal from entry to the processor, depending upon the contents of the register.

The principal object of this invention is to provide a socket in a computer system that will automatically accept any one of a plurality of types of processors having assigned pins for conducting specified signals and having a common basic input/output system code, irrespective of dissimilarities between specified signals and assigned pins.

This and other objects will be made evident in the detailed description that follows.

Fig. 1 is a schematic diagram of the socket of this invention.

Fig. 2 is a block diagram of the processor, PAL and associated components.

Fig. 3 is a more extensive diagram than Fig, 2 of the processor, PAL and the associated components.

This invention enables a user to interchange any one of a family of processors by simply inserting the processor into a socket. The user does not have to insert any jumpers or throw any switches. Any changes requised in the processor socket because of dissimilarity of correspondence between specified signals and assigned pins is completely transparent to the user. The following description details the system used to obtain this result.

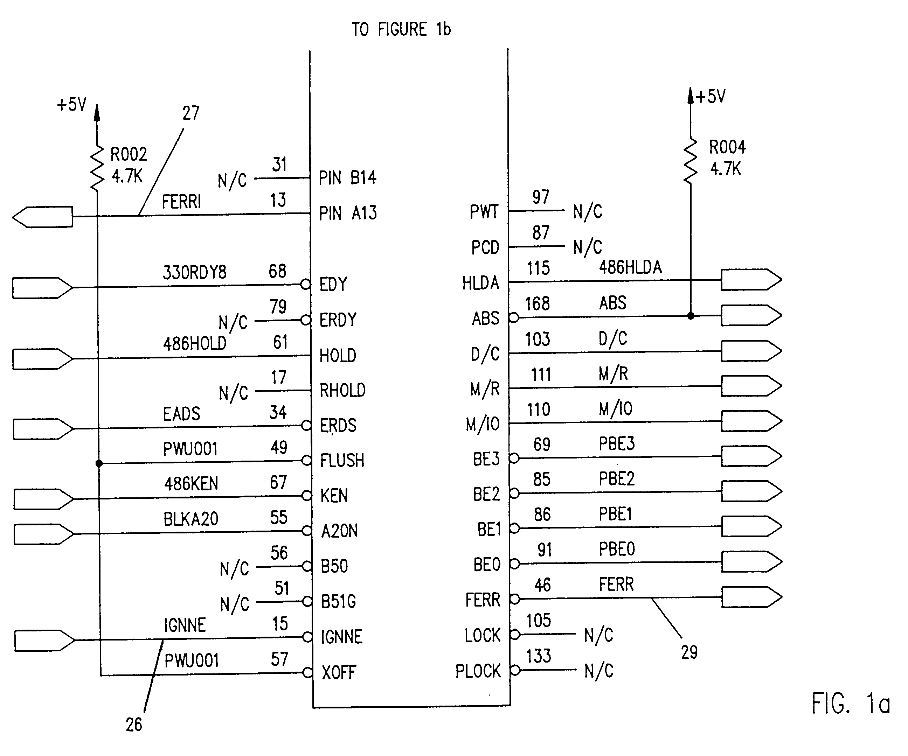

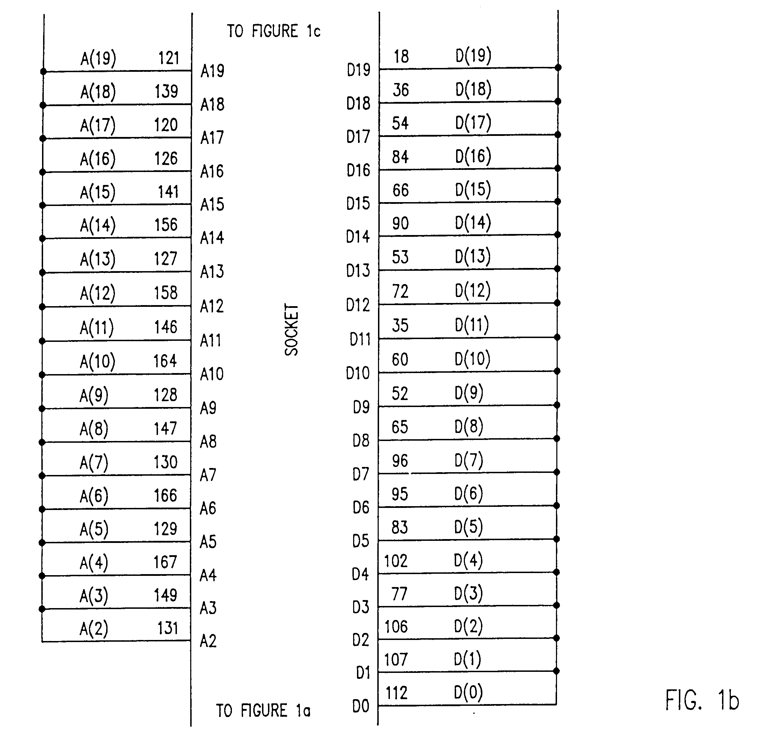

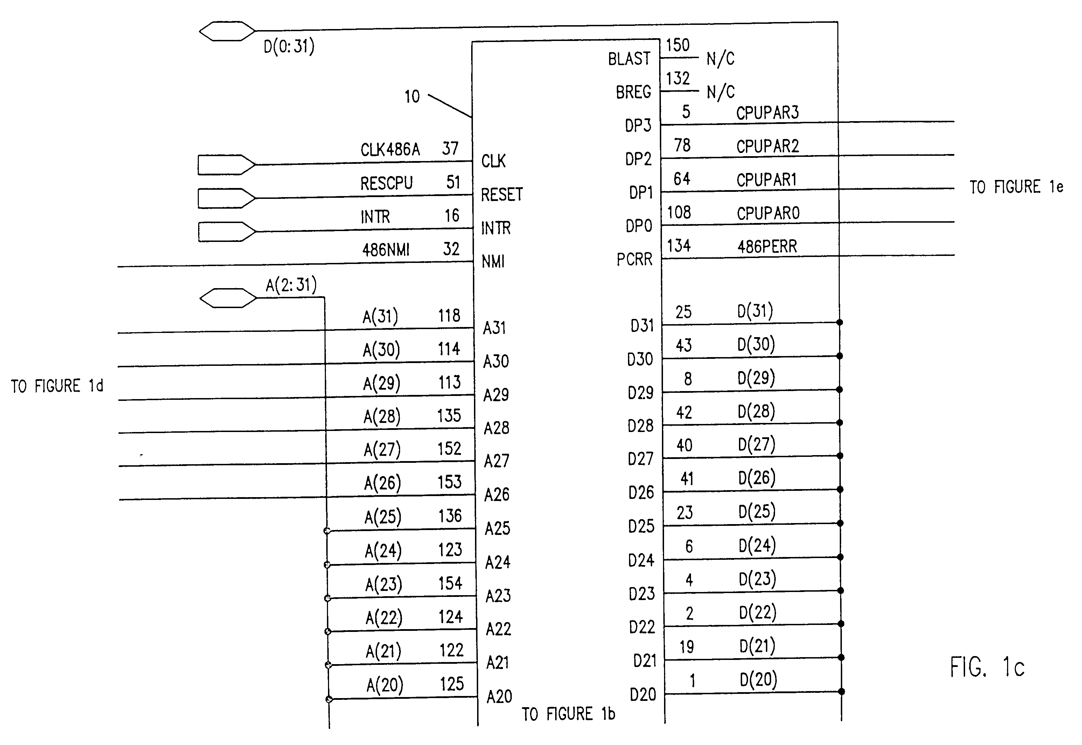

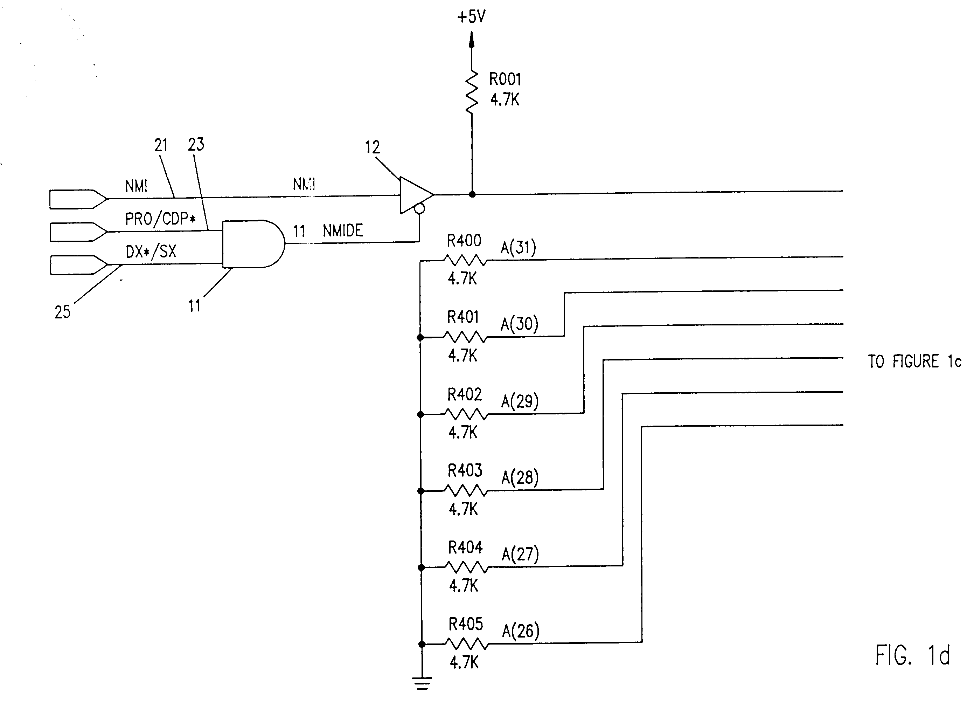

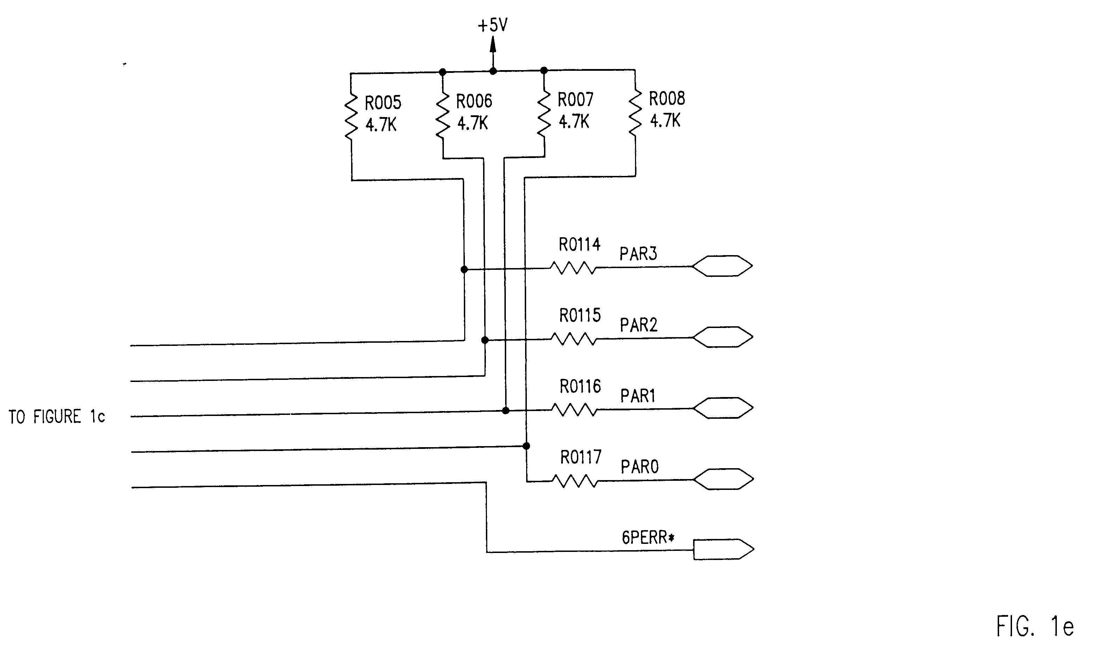

Fig. 1 shows socket 10 with terminal 26 carrying signal IGNNE*, terminal 27 carrying signal FERR1*, terminal 29 carrying signal FERR*, and terminal 21 carrying signal NMI. Signals PRO/COP* and DX*/SX are combined in AND gate 11 to gate signal NMI through buffer 12. The "*" is used to denote assertion of a low signal level.

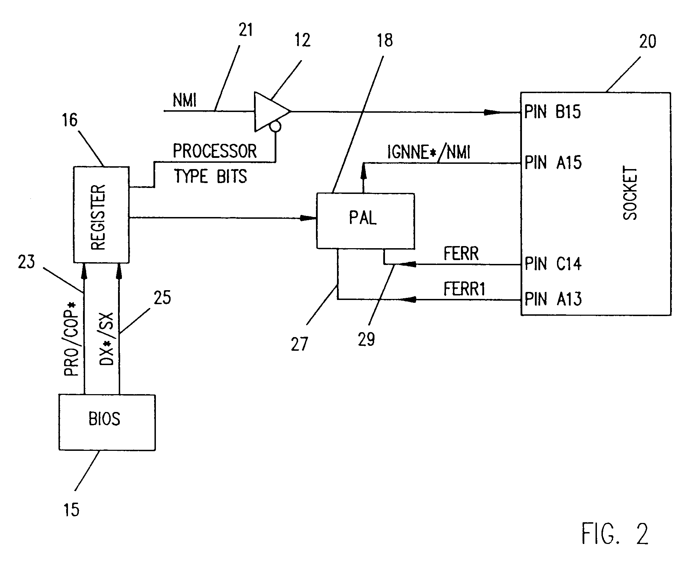

Fig. 2 illustrates socket 10 with the necessary circuitry for enabling the redirection of specified signals to different pins, depending upon the type of processor used.

PAL 18 is shown having output IGNNE*/NMI connected to pin a15 of processor 20. Pins c14 and a13 carries signals FERR* or FERR1*, respectively, to PAL 18. PAL 18, in this preferred embodiment, is a type 16R4-7. PAL 18 redirects signal FERR* (and FERR1*, as designated for the type 80487SX) when required.

In this preferred embodiment, only signals NMI, and IGNNE* are required to be redirected. One of signals FERR* and FERR1* is selected depending upon the type of processor. The following table illustrates the map for these signals.

## Pin Numbers

| Symbol | 80486DX | 80486SX | 80487SX |
|---|---|---|---|
| FERR* | C14 | NC | A13 |
| IGNNE* | A15 | NC | A15 |
| NMI | B15 | A15 | B15 |
| NC: No Connect | | | |

Table 1 Comparative Pin Differences.

BIOS 15 of any of the processors includes a program for detecting the processor type when the computer system ist powers up. The ID is provided by the processor itself and the program supplied by the BIOS 15 codes that ID into a two bit binary code and stores it in register 16. BIOS 15 also has a program for detecting the presence or absence of a coprocessor, thereby adding to the identification of the processor. This formation is coded into one bit in register 16 and is shown as signal PRO/COP*. The ID is shown as signal DX*/SX from BIOS 15 into register 16. The programs for determining this full identification are listed below.

```
configure_processor_type:
          shld    eax,edx,24                    ;processor rev ID in AH

     ; DX/SX processor type check -
     ;      if rev ID matches that of 486SX then SX else assume DX

          mov     al,PORT_XXHIGH_INIT_VAL

          and     ah,11110000b                  ;Mask off minor revision number
          cmp     ah,i486SX_REV_ID              ;If CPU rev not same as 486SX/487SX
          je      its_an_sx

          or      al,10000000b                  ;Then set to DX processor
          and     al,not 01000000b

          cmp     ah,i486_P23T_REV_ID
          je      its_P23T_P24                  ;P23T and P24

          mov     ah,al
          jmp     finish_cpu_pin_setup
its_P23T_P24:
          out     PORT_XXHIGH,al
          mov     ah,al                         ;Save PORT_XXHIGH

          out     MATHBSY,al
          fninit
          fldcw   cs:unmasked_error_cw
          fstp    st(0)                         ;Force an FP error
          fnstsw  word ptr cs:[0]

          WAFORIO
          WAFORIO

          mov     al,10b                        ;Read IRR
          out     0a0h,al
          in      al,0a0h

          out     MATHBSY,al                    ;Clear the pending error
          fninit
          fldcw   cs:normal_cw

          test    al,20h                        ;Check furry part
          jnz     finish_cpu_pin_setup          ;If error, P-24 - already done

          or      ah,01000000b
          and     ah,not 10000000b
          jmp     finish_cpu_pin_setup
unmasked_error_cw           dw      0340h
normal_cw                   dw      037fh

its_an_sx:
          and     al,00111111b                  ;Else it is SX. Now see if 486 or 487

;.Coprocessor presence determination -
;      1. Write to a memory location,
;      2. reset FPU,
;      3. store FPU's control word in the same memory location,
;      4. if FPU is present the memory location contents will have
;            changed (to the FPU's control word).
; Note - Since no RAM has been established yet, we use the cache memory
;            under the ROM.
```

5

```
        mov     ebx,cr0
        or      ebx,60000000h                ;Force 486 cache off
        mov     cr0,ebx
        invd

try_cpu_guess_again:                     ;Do not change any code after this label,
                                         ;unless you truly understand the different
                                         ;ways we may get here.

        and     al,not PORT_XX_LOAD_RAM_M     ;Turn on cache program mode
        or      al,20h

        lidt    cs:cpu_guess_tab
        out     PORT_XXHIGH,al

                ;Address bit 3 - 1 means writable
                ;Address bit 2 - 1 means not cachable

        mov     bx, 0F000h
        mov     ds, bx
        xor     bx, bx
        mov     cx,1*4                       ;F block, 16K or 32K units (note
                                             ;that for 32k units cx=2 is enough,
                                             ;but 4 works for 16k as well as 32k)

        align   16
cache_486_init_loop_coproc:
        mov     dx, ds:[bx]+0100b            ;writable, cachable
        add     bx, 4000h
        dec     cx
        jnz     cache_486_init_loop_coproc

        and     al,not 20h
        out     PORT_XXHIGH,al
        or      al,PORT_XX_LOAD_RAM_M        ;Turn off cache program mode
        out     PORT_XXHIGH,al

        mov     ebx,cr0
        and     ebx,not 60000000h            ;Turn 486 cache on
        mov     cr0,ebx

        mov     bx,ds:[0h]                   ;read to get loc 0 into cache
        mov     word ptr ds:[0],0ffffh       ;write -1 to it
        fninit                               ;reset FPU
        fnstcw  ds:[0h]                       ;store FPU control word in loc 0
        cmp     word ptr ds:[0],0ffffh
        je      its_Not_A_487                ;if memory changed (FPU found)
                                             ;then set pro/cop pin to coprocessor
        or      al,01000000b
        mov     ah,al
        jmp     short finish_cpu_pin_setup

its_Not_A_487:                               ;here set pro/cop pin to processor
        and     al,00111111b
        mov     ah,al

finish_cpu_pin_setup:                    ;Do not change any code after this label,
                                         ;unless you truly understand the different
                                         ;ways we may get here.

        lidt    cs:cpu_set_tab

        mov     al,ah
        out     PORT_XXHIGH,al
```

The NMI signal for types 80486DX and 80487SX are applied to pin B15 through buffer 12 by the gating signal from register 16, as shown. If, however, the processor is type 80486SX, then signal NMI is applied to pin A15 via PAL 18, as shown. Signal IGNNE* is applied to pin A15 for types 80486DX and 80487SX and not connected for the type 80486SX. The operation of PAL 18 is described by the following:

```
/**   Inputs   **/

Pin 1      = palclk2      ;/* processor clock out of the clock chip      */
Pin 2      = oscclk2      ;/* copy of the above clock                    */
Pin 3      = ferr_        ;/* 486DX FERR*                                */
Pin 4      = ferrI_       ;/* 487SX FERR*                                */
Pin 5      = pro_cop      ;/* 1 - using a 486SX, 0 - using a 487SX       */
Pin 6      = dx_sx        ;/* 1 - using a DX, 0 - using an SX            */
Pin 7      = resnpx       ;/* not used anymore                           */
Pin 8      = bsy386_      ;/* signal to processor that coproc is busy    */
Pin 9      = !oe_         ;/* testability pin.  oe_ = 0 is enabled       */
Pin 11     = !roe_        ;/* testability pin for registered outputs     */
Pin 12     = nmi          ;/* NMI from the system                        */

/**   Outputs   **/

Pin 13     = errnpx_      ;/* coprocessor error to the 330               */
Pin 14     = ignne_       ;/*                                            */
Pin 15     = ferrd_       ;/* ferr* delayed by one clock                 */
Pin 16     = bsynpx_      ;/* coprocessor busy                           */
Pin 17     = clk2by2      ;/* processor clock divided by 2               */
Pin 18     = clk2syn      ;/* aligned CLK2                               */
Pin 19     = !clksyn      ;/* aligned CLK1                               */

/**   Logic Equations   **/

clk2by2.d  = !clk2by2 ;


        clksyn     = !oscclk2 & clk2by2    /* Take skew out of clk2 and clk1 by */
                   # clksyn & clk2by2      /* making sure both clocks are generate
                   # clksyn & oscclk2 ; /* off of the same edge */

        clk2syn    = !oscclk2 ;

        errnpx_    = bsynpx_ ;

        $define    s0     'b'111
        $define    s1     'b'001
        $define    s2     'b'011
        $define    s3     'b'010
        $define    s4     'b'110
        $define    s5     'b'000
        $define    s6     'b'100
        $define    s7     'b'101

        FIELD      npxerr  =  [ferrd_, bsynpx_, ignne_];

        SEQUENCE   npxerr {

        present    s0
            if !nmi & pro_cop & !dx_sx next s4 ;   /* 486SX nmi steering */
            if !ferr_ & dx_sx next s1 ;
            if !ferrI_ & !dx_sx & !pro_cop next s1 ;
            default next s0 ;
```

```
present    s1
   if ferr_ & dx_sx next s0 ;                /* return if error went away */
   if ferr1_ & !dx_sx & !pro_cop next s0 ;
   if pro_cop & !dx_sx next s4 ;            /* if 486SX, route to S4 */
   default next s2 ;

present    s2
   if bsy386_ next s3 ;            /* goes not busy when portF0 written to
   if ferr_ & dx_sx next s0 ;
   if ferr1_ & !dx_sx & !pro_cop next s0 ;
   if pro_cop & !dx_sx next s4 ;
   default next s2 ;

present    s3
   if ferr_ & dx_sx next s0 ;
   if ferr1_ & !dx_sx & !pro_cop next s0 ;
   if pro_cop & !dx_sx next s4 ;
   default next s3 ;

present    s4
   if nmi & pro_cop & !dx_sx next s0 ;    /* wait for 486SX nmi */
   if dx_sx next s0 ;
   if !dx_sx & !pro_cop next s0 ;
   default next s4 ;

present    s5
   next s0 ;

present    s6
   next s0 ;

present    s7




   next s0 ;

}

clksyn.oe  = oe_ ;
clk2syn.oe = oe_ ;
errnpx_.oe = oe_ ;
```

Assume that a type 80486SX processor is installed in the socket 10. In that case, signal NMI is blocked by gate 12 from pin B15 of socket 10. Signal NMI is redirected through PAL 18 to pin A15, the correct pin as indicated in table 1. That is the only redirection required in that instance. When a type 80487SX processor is installed, the NMI signal is gated through buffer 12 to pin B15 of socket 10. Signal IGNNE* is gated by the PAL to pin A15. Pin A13 is scanned for its indication of signal FERR1*.

When a type 80486DX processor is installed, signal NMI is gated through buffer 12 and impressed on pin B15. Signal IGNNE* is gated by the PAL to Pin A15. Pin C14 is scanned for its indication of signal FERR*. In this manner, it is shown that at least three different processors from the same family may each be installed in a single socket without the user having to take any further steps or precautions.

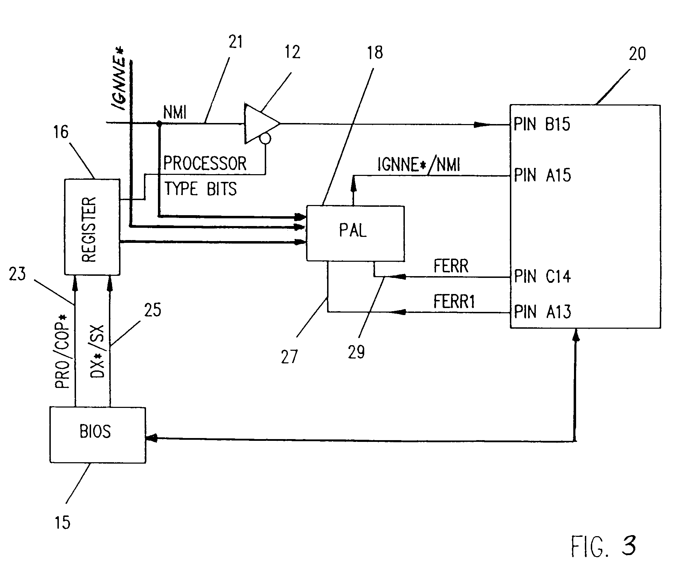

Fig. 3 represents that part of the computer system which is capable of monitoring selected signals from the processor and of providing connections in accordance with those signals.

Referring to Fig. 3, the processor 20 is connected to its basic input/output system (BIOS) memory 15, the BIOS memory 15 is connected to a register 16 and the register 16 is connected to a gate 12 and to a programmable array logic (PAL) circuit 18. The PAL circuit 18 is connected to the pins A13, C14 and A15 of the processor 20. The gate 12 is connected to the pin B15 of the processor 20.

The PAL circuit 18 has input signal lines IGNNE* and NMI and the gate 12 has an input signal line NMI. The PAL circuit 18 is capable of connecting pin A15 of the processor 20 either to the signal line IGNNE* or to the signal line NMI and the gate 12 is capable of connecting the signal line NMI to the pin B15 of the processor 20 or to blocking that connection. The PAL circuit 18 is controlled by data from the register 16 and by the signals FERR and FERR1 provided by the processor ports connected respectively to the pins C14 and A13.

In the operation of the part of the system shown in Fig. 3, when the PAL circuit 18 connects the signal line IGNNE* to the pin A15 of the processor 20 the gate 12 connects the signal line NMI to the pin B15 of the processor 20, and when the PAL circuit 18 connects the signal line NMI to the pin A15 of the processor 20 the gate 16 blocks the signal line NMI from the pin B15 of the processor 20.

Table 1, below, shows that for an Intel Type 80486DX main processor, the signal FERR is provided at pin C14, the signal IGNNE is required at pin A15 and the signal NMI is required at pin B15. Alternatively, for an Intel Type 80486SX main processor, there is no signal FERR, the signal IGNNE is not required and the signal NMI is required at pin A15. For an Intel Type 80487SX coprocessor, the signal FERR is provided at pin A13, the signal IGNNE is required at pin A15 and the signal NMI is required at pin B15.

The arrangement shown in Fig. 3 can provide each of the three sets of conditions set out in Table 1.

## Claims

1. A computer system including one of a family of processors capable of operating with the same basic input/output system (BIOS) code and having packages with the same pattern of terminals that require respective assigned signal-to-terminal connections that are the same except for a first terminal, package-mounting means effecting the assigned signal-to-terminal connections for the processor, and control means for detecting which one of the processors is fitted to the package-mounting means and for selecting the signal connection to the first terminal according to which processor is fitted to the package-mounting means.

2. A computer system as claimed in claim 1, which includes one of a family of processors having respective assigned signal-to-terminal connections that are the same except for a first terminal and a second terminal, and control means which connects a first selected signal to the first terminal for a first of the processors and connects that signal to the second terminal for another of the processors.

3. A computer system as claimed in claim 2, wherein for one of the processors the control means connects a second selected signal to the second terminal when the first selected signal is connected to the first terminal.

4. A computer system as claimed in claim 2 wherein, for one of the processors, the control means blocks all connections to the first terminal when the first selected signal is connected to the second terminal.

5. A computer system as claimed in any one of claims 1 to 4, wherein the control means includes a memory containing a program for identifying the processor, the memory being connected to the processor, and a logic circuit connected between the memory and the processor for effecting signal connections to the first terminal of the processor.

6. A computer system as claimed in claim 5, wherein the logic circuit includes a register for storing data identifying the processor.

7. A computer system as claimed in claim 6, wherein the memory includes a program for identifying the processor and a program for storing data identifying the processor in the register in the logic circuit.

8. A computer system as claimed in claim 7, wherein the program for identifying the processor is capable of distinguishing between a main processor and a coprocessor.

9. A computer system as claimed in any one of claims 5 to 8, wherein the memory includes basic input/output system (BIOS) code for the processor.

10. A computer system as claimed in any one of claims 1 to 9, wherein the package-mounting means is a socket for engaging pins on the processor package.

FIG. 1a

TO FIGURE 1b

+5V
R004
4.7K

| Pin | Signal | Net |
|---|---|---|
| 97 | PWT | N/C |
| 87 | PCD | N/C |
| 115 | HLDA | 486HLDA |
| 168 | ABS | ABS |
| 103 | D/C | D/C |
| 111 | M/R | M/R |
| 110 | M/IO | M/IO |
| 69 | BE3 | PBE3 |
| 85 | BE2 | PBE2 |
| 86 | BE1 | PBE1 |
| 91 | BE0 | PBE0 |
| 46 | FERR | FERR |
| 105 | LOCK | N/C |
| 133 | PLOCK | N/C |

29

+5V
R002
4.7K

27

| Pin | Signal | Net |
|---|---|---|
| 31 | PIN B14 | N/C |
| 13 | PIN A13 | FERRI |
| 68 | EDY | 330RDY8 |
| 79 | ERDY | N/C |
| 61 | HOLD | 486HOLD |
| 17 | RHOLD | N/C |
| 34 | ERDS | EADS |
| 49 | FLUSH | PWU001 |
| 67 | KEN | 486KEN |
| 55 | A20N | BLKA20 |
| 56 | B50 | N/C |
| 51 | B51G | N/C |
| 15 | IGNNE | IGNNE |
| 57 | XOFF | PWU001 |

26

FIG. 1b

SOCKET

TO FIGURE 1c

TO FIGURE 1a

| | | |
|---|---|---|
| D19 | 18 | D(19) |
| D18 | 36 | D(18) |
| D17 | 54 | D(17) |
| D16 | 84 | D(16) |
| D15 | 66 | D(15) |
| D14 | 90 | D(14) |
| D13 | 53 | D(13) |
| D12 | 72 | D(12) |
| D11 | 35 | D(11) |
| D10 | 60 | D(10) |
| D9 | 52 | D(9) |
| D8 | 65 | D(8) |
| D7 | 96 | D(7) |
| D6 | 95 | D(6) |
| D5 | 83 | D(5) |
| D4 | 102 | D(4) |
| D3 | 77 | D(3) |
| D2 | 106 | D(2) |
| D1 | 107 | D(1) |
| D0 | 112 | D(0) |

| | | |
|---|---|---|
| A19 | 121 | A(19) |
| A18 | 139 | A(18) |
| A17 | 120 | A(17) |
| A16 | 126 | A(16) |
| A15 | 141 | A(15) |
| A14 | 156 | A(14) |
| A13 | 127 | A(13) |
| A12 | 158 | A(12) |
| A11 | 146 | A(11) |
| A10 | 164 | A(10) |
| A9 | 128 | A(9) |
| A8 | 147 | A(8) |
| A7 | 130 | A(7) |
| A6 | 166 | A(6) |
| A5 | 129 | A(5) |
| A4 | 167 | A(4) |
| A3 | 149 | A(3) |
| A2 | 131 | A(2) |

TO FIGURE 1e

FIG. 1c

| | | |
|---|---|---|
| BLAST | 150 | N/C |
| BREG | 132 | N/C |
| DP3 | 5 | CPUPAR3 |
| DP2 | 78 | CPUPAR2 |
| DP1 | 64 | CPUPAR1 |
| DP0 | 108 | CPUPAR0 |
| PCRR | 134 | 486PERR |
| D31 | 25 | D(31) |
| D30 | 43 | D(30) |
| D29 | 8 | D(29) |
| D28 | 42 | D(28) |
| D27 | 40 | D(27) |
| D26 | 41 | D(26) |
| D25 | 23 | D(25) |
| D24 | 6 | D(24) |
| D23 | 4 | D(23) |
| D22 | 2 | D(22) |
| D21 | 19 | D(21) |
| D20 | 1 | D(20) |

TO FIGURE 1b

D(0:31)

10

| | | |
|---|---|---|
| CLK486A | 37 | CLK |
| RESCPU | 51 | RESET |
| INTR | 16 | INTR |
| 486NMI | 32 | NMI |
| A(31) | 118 | A31 |
| A(30) | 114 | A30 |
| A(29) | 113 | A29 |
| A(28) | 135 | A28 |
| A(27) | 152 | A27 |
| A(26) | 153 | A26 |
| A(25) | 136 | A25 |
| A(24) | 123 | A24 |
| A(23) | 154 | A23 |
| A(22) | 124 | A22 |
| A(21) | 122 | A21 |
| A(20) | 125 | A20 |

A(2:31)

TO FIGURE 1d

13

EP 0 534 770 A2

+5V

R001
4.7K

21  23

NMI

PRO/CDP*

DX*/SX

25      11

12

NMI

11  NMIDE

R400  A(31)
4.7K

R401  A(30)
4.7K

R402  A(29)
4.7K

R403  A(28)
4.7K

R404  A(27)
4.7K

R405  A(26)
4.7K

TO FIGURE 1c

FIG. 1d

FIG. 1e

TO FIGURE 1c

EP 0 534 770 A2

FIG. 2

FIG. 3